# FASCICULE DE BREVET EUROPEEN

(11) **EP 0 568 421 B1**
(45) Date de publication et mention de la délivrance du brevet: **18.06.1997**
(21) Numéro de dépôt: 93401052.1
(22) Date de dépôt: 22.04.1993
(51) Int. Cl.: H01L 23/60, H02H 9/04, H01L 29/74, H01L 29/87

(54) **Dispositif de protection d'un circuit intégré contre les décharges électrostatiques**
Schutzvorrichtung einer integrierten Schaltung gegen elektrostatische Entladungen
Protection device of an integrated circuit against electrostatic discharges

(30) Priorité: 30.04.1992 FR 9205422
(43) Date de publication de la demande: 03.11.1993
(73) Titulaire: SGS-THOMSON MICROELECTRONICS S.A., 94250 Gentilly (FR)
(72) Inventeur: Tailliet, François, F-75116 Paris (FR)
(74) Mandataire: Schmit, Christian Norbert Marie

(56) Documents cités:
- WO-A-90/14691
- GB-A- 2 092 826
- US-A- 4 939 616
- US-A- 5 012 317
- PATENT ABSTRACTS OF JAPAN vol. 8, no. 161 (E-257)(1598) 26 Juillet 1984
- PATENT ABSTRACTS OF JAPAN vol. 15, no. 159 (E-1059)22 Avril 1991
- PATENT ABSTRACTS OF JAPAN vol. 11, no. 309 (E-547)(2756) 8 Octobre 1987

## Description

L'invention concerne les circuits-intégrés, et plus précisément les dispositifs de protection d'un circuit contre les surtensions d'origine électrostatique pouvant apparaître sur les plots de connexion extérieure du circuit.

Les surtensions peuvent provenir notamment de la manipulation des puces de circuit intégré soit au cours de la fabrication soit au cours de l'utilisation, et elles peuvent atteindre plusieurs dizaines de kilovolts. Elles sont donc susceptibles de détruire le circuit intégré.

C'est pourquoi des dispositifs de protection sont prévus dans la puce, en général à proximité immédiate de chaque plot de connexion, interposés entre ce plot et les éléments de circuit qui pourraient être endommagés par la surtension.

Les dispositifs de protection habituels utilisent principalement des résistances et des diodes ou des transistors, pour d'une part limiter le courant susceptible de circuler dans la puce en cas de décharge, et d'autre part écrêter les tensions susceptibles d'être transmises aux éléments de circuit à protéger.

Un dispositif de protection classique utilise par exemple un transistor bipolaire latéral interposé entre un plot de connexion et la masse. Dans le cas habituel d'un substrat semiconducteur de type P⁻, le collecteur du transistor est une diffusion superficielle de type N+ raccordée au plot; l'émetteur est une autre région superficielle de type N+ diffusée dans le substrat et raccordée à la masse; la base est constituée par le substrat entre les deux diffusions N+; le substrat est en principe aussi à la masse.

En cas de surtension positive importante apparaissant sur le plot (surtension mesurée par rapport à la masse), le transistor bipolaire latéral passe en avalanche (avalanche de la jonction collecteur-base). Le seuil de déclenchement de l'avalanche est d'environ 20 volts dans les technologies usuelles. Aussitôt l'avalanche déclenchée, le transistor devient fortement conducteur et dissipe l'énergie de la décharge électrostatique apparue sur le plot. Mais sa résistance interne dans l'état conducteur n'est pas nulle. En pratique une chute de tension d'au moins 10 volts environ subsiste entre le collecteur et l'émetteur, c'est-à-dire entre le plot et la masse.

Il y a alors production de chaleur importante du fait du courant élevé qui peut passer alors que la tension résiduelle est également forte. Il y a risque de destruction thermique de la puce.

On pourrait envisager d'utiliser un thyristor plutôt qu'un transistor pour accomplir la même fonction, car un thyristor présente la particularité d'avoir une très faible chute de tension résiduelle entre ses bornes une fois que sa conduction est déclenchée.

L'inconvénient d'une telle structure est le risque de déclenchement intempestif du thyristor et donc sa mise en court-circuit dans des cas où ce ne serait pas strictement nécessaire compte-tenu de l'énergie limitée dissiper. Pour ces cas, une protection par transistor latéral suffirait et l'énergie dissipée même sous 10 volts ne détruirait pas le composant. Mais avec un thyristor on aboutit à un autre risque : si on suppose par exemple que le plot à protéger est un plot d'alimentation à 5 volts, ce plot se retrouve en court-circuit avec la masse dès que le thyristor se déclenche, détruisant la connexion d'amenée de courant sur ce plot.

Compte-tenu de ces problèmes, la présente invention, qui est spécifiée dans la revendication 1, propose un circuit intégré comportant au moins un plot de connexion protégé contre les surtensions susceptibles d'apparaître sur ce plot (notamment en raison de décharges électrostatiques), ce dispositif de protection ayant les particularités suivantes : il comprend une structure intégrée de thyristor connectée entre le plot de connexion et une masse électrique du circuit, ce thyristor comprenant quatre régions semiconductrices alternées successives PNPN parmi lesquelles une région extrême de l'alternance, et une région intermédiaire dite région de gâchette adjacente à la région extrême, ces deux régions étant reliées au plot, avec une résistance de faible valeur interposée entre la région de gâchette et le plot.

Cette résistance de faible valeur (ordre de grandeur : quelques ohms) a pour rôle d'augmenter la valeur du courant de déclenchement du thyristor par rapport à ce que serait ce courant de déclenchement si la région de gâchette était flottante.

On s'est aperçu en effet selon l'invention que les inconvénients liés à l'utilisation d'un thyristor résultaient surtout de ce que le thyristor avait tendance à se déclencher trop facilement; il se déclenche même lorsque la décharge électrostatique dont il faut se protéger conduit à des courants relativement modérés.

On notera que le brevet US 4 939 616 montre une structure avec une résistance placée de la même manière servant à limiter le courant dans un transistor pour éviter sa destruction.

L'idée de l'invention est de relever le courant de déclenchement d'une quantité importante. Ainsi on peut faire en sorte par exemple que le courant de déclenchement ait une valeur se rapprochant du courant limite qui serait acceptable d'un point de vue thermique avec une chute de tension d'une dizaine de volts. Le thyristor ne se déclenchera qu'au delà de ce courant.

De préférence la valeur de la résistance est telle que le courant de déclenchement du thyristor soit d'au moins 100 milliampères et si possible d'environ 200 à 500 milliampères, voire même 1 ampère. Ceci conduit à une résistance d'environ 1 ohm (pour 600 milliampères) à 6 ohms (pour 100 milliampères).

La résistance est de préférence réalisée dans une couche métallique ou une couche de silicium polycristallin déposée sur le circuit intégré et gravée selon une forme et des dimensions correspondant à la valeur de résistance à réaliser.

Le thyristor peut être constitué de la manière suivante: première région de type N+ diffusée superficiellement dans un substrat de type P⁻ et en contact avec un conducteur de masse du circuit; deuxième région constituée par une zone de substrat P⁻ située entre la première région et un caisson N⁻ diffusé dans le substrat; troisième région (région de gâchette) constituée par le caisson de type N⁻; quatrième région de type P+ diffusée superficiellement dans le caisson de type N⁻ et en contact direct avec le plot de connexion.

La résistance de faible valeur est connectée entre le plot et le caisson N⁻.

De préférence, une cinquième région diffusée de type N+ est formée au dessus de la jonction entre le caisson N⁻ et le substrat, cette région servant de contact ohmique pour la liaison entre le caisson N⁻ et la résistance. Cette cinquième région s'étend de préférence également en dehors du caisson, à la surface du substrat P⁻; à son extrémité située hors du caisson, elle est reliée à une entrée proprement dite du circuit intégré. Dans le caisson, cette cinquième région sert de contact avec la région de gâchette et c'est elle qui est reliée à la résistance de faible valeur.

D'autres caractéristiques et avantages de l'invention apparaîtront à la lecture de la description détaillée qui suit et qui est faite en référence aux dessins annexés dans lesquels :
- la figure 1 représente un schéma équivalent de circuit de protection selon l'invention;
- la figure 2 représente, en coupe latérale selon la ligne II-II de la figure 3, la structure de protection selon un premier mode de réalisation préféré de l'invention;
- la figure 3 représente, en vue de dessus, la structure de protection selon le premier mode de réalisation, dans laquelle on a représenté les différentes zones diffusées mais pas les métallisations;
- la figure 4 représente en vue de dessus les métallisations recouvrant la structure de protection;
- la figure 5 représente une courbe courant-tension schématisant le comportement de la structure de protection;
- la figure 6 représente, en coupe latérale, un deuxième mode de réalisation de l'invention;
- la figure 7 représente une vue de dessus du deuxième mode de réalisation.

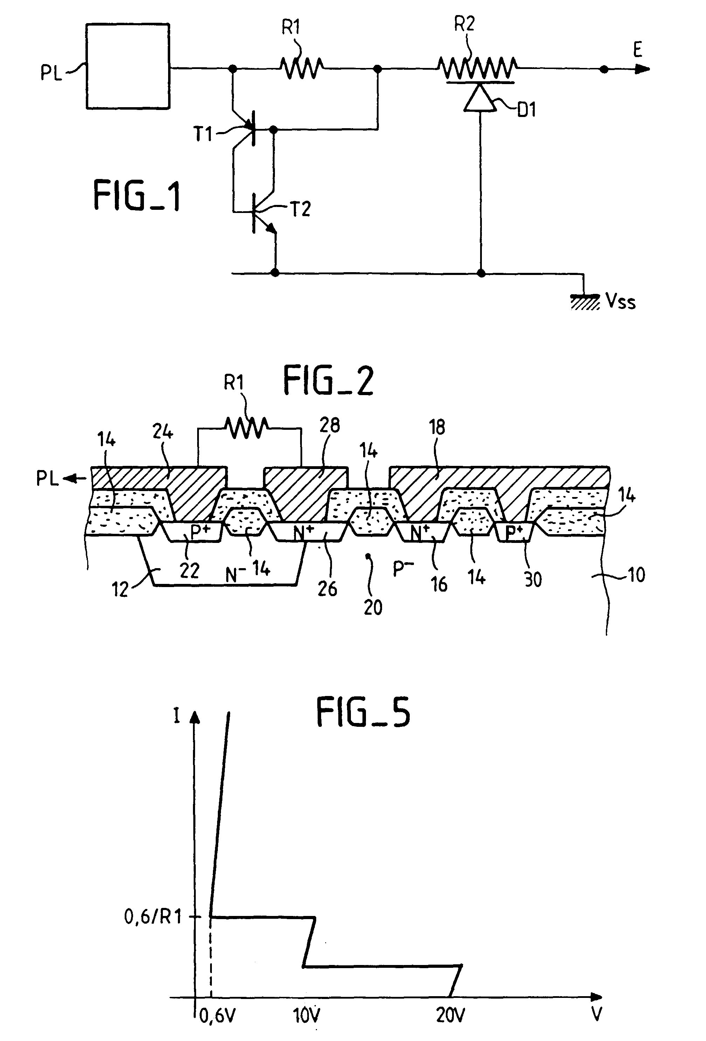

Sur la figure 1, la référence PL désigne un plot de connexion extérieure d'une puce de circuit intégré. Ce plot doit être protégé contre des surtensions d'origine électrostatique. Ce plot sert de borne d'accès pour transmettre un courant ou une tension entre l'extérieur de la puce et les circuits internes (non représentés) de la puce; sur la figure 1, le noeud E représente un point de circuiterie interne ainsi relié au plot d'accès PL. Les éléments de circuit intermédiaires entre le plot PL et le noeud E font partie du circuit de protection selon l'invention.

L'élément essentiel de ce circuit de protection est un thyristor placé entre le plot et une masse électrique Vss du circuit intégré. Le thyristor est une succession de quatre régions semiconductrices de types de conductivité alternés PNPN, classiquement représenté par un transistor PNP T1 imbriqué avec un transistor NPN T2, la base de chaque transistor étant reliée au collecteur de l'autre.

L'émetteur du transistor NPN constitue une première borne extrême du thyristor et est reliée à la masse Vss. L'émetteur du transistor PNP constitue une deuxième borne extrême du thyristor et est reliée au plot PL. La base du transistor PNP, c'est-à-dire aussi le collecteur du transistor NPN, constitue la région de gâchette du thyristor.

La région de gâchette est ici reliée au plot PL, non pas directement mais à travers une résistance R1 de faible valeur. Elle est aussi reliée à l'entrée E du circuit intégré par une résistance R2. Cette résistance R2 est en pratique, comme on le verra, réalisée sous forme d'une bande diffusée N+ dans un substrat P, ce qui constitue en même temps une jonction NP allongée s'étendant sur toute la longueur de la résistance; c'est pourquoi on a représenté sur la figure 1 une diode D1 entre la résistance R2 et la masse, cette diode étant répartie sur toute la résistance.

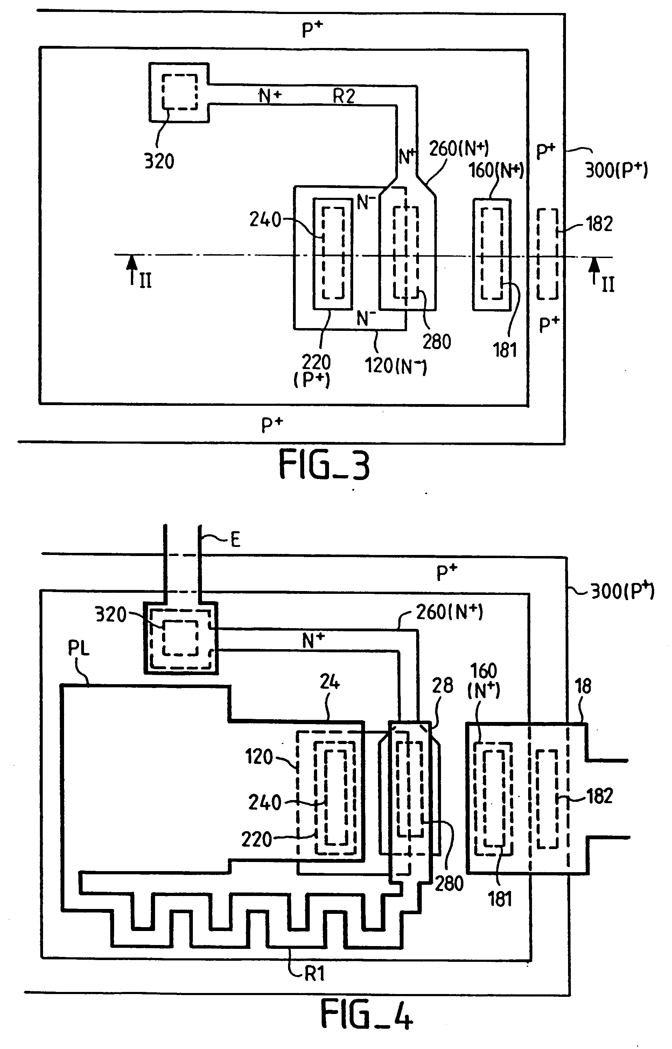

La réalisation pratique de cette structure de protection peut se faire comme représenté à la figure 2 et à la figure 3. La figure 3 est une vue de dessus des régions diffusées, sans les métallisations; la figure 2 est une coupe transversale selon la ligne II-II de la figure 3. La figure 2 est à une échelle agrandie par rapport à la figure 3.

Le substrat de la puce de circuit intégré est de préférence une couche épitaxiale 10 de silicium de type P⁻. Ceci n'est cependant pas nécessaire. En effet la plupart des circuits CMOS n'ont pas de couche épitaxiale, entre autres pour des raisons de coût. Dans ce substrat est diffusé un caisson profond N⁻ 12. Des diffusions superficielles d'impuretés de type P+ et N+, moins profondes et plus dopées que le substrat et le caisson, sont formées à la surface de la puce, à la fois dans le caisson et dans le substrat et même éventuellement à cheval sur la frontière entre le caisson et le substrat. Ces diffusions superficielles sont séparées les unes des autres par des régions isolantes 14, formées en principe par oxydation thermique profonde du silicium.

Le thyristor comporte les régions successives suivantes : une première région 16 constituée par une zone superficielle dopée de type N+ dans le substrat P⁻, cette zone étant éloignée du caisson 12. Cette première région est en contact direct avec un conducteur 18 qui est une métallisation (aluminium en général) reliée à la masse Vss.

Une deuxième région du thyristor est une zone superficielle du substrat P⁻ (c'est-à-dire non autrement dopée), située entre la région N+ 16 et le caisson 12.

La troisième région du thyristor est le caisson N⁻ 12. C'est la région de gâchette.

La quatrième région est une zone superficielle 22 de type P+ diffusée dans le caisson 12. Elle est en contact direct avec un conducteur 24 qui est une métallisation (aluminium) reliée directement au plot PL non visible sur la figure 2.

La résistance R2 de la figure 1 est de préférence constituée par une bande superficielle 26 dopée de type N+ comportant à la fois une partie dans le caisson 12 et une partie dans le substrat 10 en dehors du caisson. Sur la figure 2, on a représenté cette bande à un endroit où elle chevauche la bordure du caisson.

On utilise la partie de bande 26 qui est dans le caisson comme contact ohmique d'accès au caisson. Cette partie constitue une première extrémité de la résistance R1 de la figure 1; c'est l'extrémité qui est reliée à la gâchette, c'est-à-dire à la base du transistor PNP T1. L'autre extrémité de la résistance R1 est le conducteur 24 relié au plot PL. Entre les deux, sur la figure 2, la résistance R1 n'a été représentée que sous forme symbolique.

La résistance R1 peut être réalisée de préférence par une métallisation gravée, faisant partie du même niveau de métallisation que le plot PL, le conducteur 24 et le conducteur 18. L'extrémité 28 de cette métallisation en contact avec la région N+ 26 est visible sur la figure 2. De cette façon on aboutit à une valeur faible de cette résistance alors que sa réalisation sous une forme diffusée, du fait des résistances présentes (en série) à l'endroit des connexions de la bande diffusée au circuit, ne peut conduire qu'à des résistances trop fortes.

La résistance R1 peut aussi être réalisée par un niveau de métallisation différent du niveau du plot PL ou des autres conducteurs. Elle peut également être réalisée par une couche gravée de silicium polycristallin en contact d'un côté avec le conducteur 24 et de l'autre avec la région 26.

Pour terminer la description de la figure 2, il faut encore mentionner que le conducteur de masse à Vss (métallisation 18) est de préférence en contact direct avec le substrat par l'intermédiaire d'une zone dopée 30 de type P+ diffusée superficiellement dans le substrat. La région N+ 16 est située entre le caisson et la zone P+ 30.

Sur la figure 3 on a désigné par la référence 120 le contour du caisson N⁻; 160 le contour de la région N+ 16; 220 le contour de la région P+ 22; 260 le contour de la région N+ 26 à la fois au dehors et en dedans du caisson 12; 300 le contour de la région P+ 30.

Les emplacements des contacts entre une métallisation et une région diffusée sont représentés par des rectangles en traits tiretés; ce sont les contacts : 181 entre la métallisation de masse 18 et la région N+ 16; 182 entre la métallisation 18 et la région P+ 30; 240 entre la métallisation 24 et la région P+ 22; 280 entre la métallisation 28 et la région N+ 26; 320 entre un conducteur d'entrée E du circuit intégré et l'extrémité de résistance R2 (région 260) la plus éloignée du caisson 12.

Sur la figure 4 on a redessiné les mêmes éléments qu'à la figure 3 avec en outre, en traits épais, les contours des différentes métallisations, dans un mode de réalisation préféré où la résistance R1 est une formée par une métallisation de même niveau que les autres métallisations du schéma.

Les différents conducteurs visibles sur la figure 4 sont : le conducteur de masse 18 en contact sur les emplacements 181 et 182 avec les régions 16 et 30 respectivement; le conducteur d'entrée E du circuit intégré, en contact avec la région 26 sur l'emplacement 320; le plot d'accès PL dont une région centrale peut recevoir un fil soudé non représenté; le conducteur 24 qui prolonge le plot PL et qui vient en contact avec la région P+ 22 sur l'emplacement 240; le conducteur 28 en contact sur l'emplacement 280 avec l'extrémité de région 26 située au dessus du caisson 12; et enfin le conducteur (de préférence étroit et allongé) constituant la résistance R1, dont une extrémité est raccordée au plot PL et l'autre au conducteur 28.

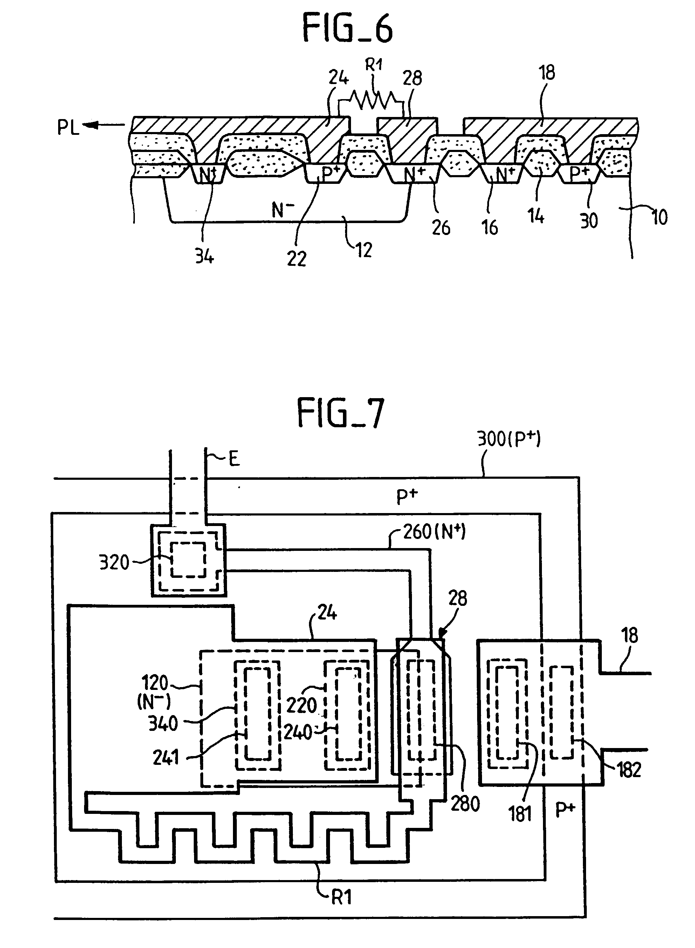

Le fonctionnement de cette structure peut se schématiser à partir de la courbe courant-tension représentée à la figure 5. Cette courbe présente le courant absorbé dans le plot en fonction de la tension entre le plot et la masse.

Lorsque la tension s'élève au dessus d'une vingtaine de volts environ, la jonction collecteur-base du transistor NPN T2 (fig 1) passe en avalanche, le transistor NPN se met à conduire un courant, et la tension entre collecteur et émetteur tombe à environ une dizaine de volts; le courant croît; si la capacité de débit de courant de la source de décharge électrostatique est limitée, la situation reste celle-ci jusqu'à la fin de la décharge; seul le transistor NPN participe à l'évacuation de la décharge. Mais si la capacité de fourniture de courant de la source de décharge est plus élevée et atteint une valeur telle que la chute de tension dans la résistance R1 dépasse 0,6 volts environ, le transistor PNP commence à conduire et la conduction du thyristor est déclenchée. Le thyristor passe alors en régime de quasi-court-circuit avec une tension résiduelle ne dépassant guère 0,7 volts à ses bornes.

On comprend donc que le déclenchement du thyristor ne se produit que si le courant de la source de décharge atteint une valeur de plusieurs centaines de milliampères dès lors qu'une résistance de quelques ohms est présente entre le plot et la gâchette. Sinon, la protection ne se fait que par le transistor NPN et la tension résiduelle aux bornes reste d'une dizaine de volts, évitant ainsi de court-circuiter par exemple une source de tension appliquée au plot.

La valeur qu'il faut donner à la résistance R1 se déduit de ce qui précède, en fonction du courant qu'on tolère dans le transistor NPN lorsqu'il a une dizaine de volts à ses bornes. Si le courant maximal accepté est I en ampères, la résistance R1 doit avoir une valeur sensiblement de 0,6/I ohms.

Des valeurs acceptables pour I seront en général comprises entre 100 milliampères et un ampère, conduisant à des résistances de 6 ohms à 0,6 ohms environ. Il s'agit donc bien de résistances de faibles valeurs.

On peut prévoir des modifications à la structure ainsi décrite, comme par exemple l'adjonction d'une diode directement entre le plot PL et le conducteur de masse, pour éviter l'endommagement de la résistance R1 en cas de décharges négatives avec fort courant.

En effet, en cas de décharge négative sur le plot, le courant tend à passer à travers le conducteur de masse 18, le substrat P⁻, le caisson N⁻, la région N+ 26, le conducteur 28, la résistance R1 et le plot PL. Si ce courant est trop important, la résistance R1 est endommagée. On prévoit donc une liaison directe entre le plot PL et le caisson 12, avec contact ohmique de type N+, qui court-circuite la résistance R1 dans ce cas.

Pour réaliser cette liaison directe, on forme une région diffusée supplémentaire 34 N+ dans le caisson 12. Elle est placée à une distance suffisante de la région P+ 22 pour ne pas gêner le fonctionnement du thyristor en cas de décharge positive. Elle est située sous le conducteur 24 ou sous le plot PL et est en contact avec l'un ou l'autre.

Les figures 6 et 7 représentent respectivement en coupe et en vue de dessus la structure correspondant à cette modification. Le contour de la diffusion supplémentaire 34 est désigné par 340 et l'emplacement de contact avec le conducteur 24 est désigné par 241.

L'ensemble de la structure selon l'invention a été décrit à propos d'un circuit intégré sur substrat P⁻ avec caisson N⁻. Il va de soi qu'une structure équivalente peut être formée en inversant tous les types de conductivité. Seule la structure sur substrat P⁻ a été décrite pour ne pas alourdir inutilement la description et les revendications.

## Revendications

1. Circuit intégré comportant au moins un plot de connexion extérieure (PL) et un dispositif de protection contre les surtensions susceptibles d'apparaître sur ce plot notamment en raison de décharges électrostatiques, ce dispositif de protection comportant une structure intégrée de thyristor connectée entre le plot et une masse électrique (18) du circuit, ce thyristor comprenant quatre régions semiconductrices alternées successives PNPN (22, 12, 20, 16) parmi lesquelles une première région extrême de l'alternance (22) et une première région intermédiaire (12) dite région de gâchette adjacente à la première région extrême sont reliées au plot, avec une résistance de faible valeur (R1) interposée entre la région de gâchette et le plot, caractérisé en ce que la résistance a une valeur suffisamment faible pour que la tension aux bornes du dispositif une fois déclenché soit plus faible quand la surtension est de forte puissance que lorsque la surtension est de faible puissance.

2. Circuit intégré selon la revendication 1, caractérisé en ce que la résistance réalisée en métal ou en silicium polycristallin a une valeur telle que le courant de déclenchement de la conduction du thyristor soit de 100 milliampères à 1 ampère.

3. Circuit intégré selon l'une des revendications 1 à 2, caractérisé en ce que la résistance a une valeur de 0,6 à 6 ohms.

4. Circuit intégré selon l'une des revendications 1 à 3, caractérisé en ce que le dispositif de protection comporte:
- un substrat, dopé de type P-,
- une région superficielle (16), dopée de type N+, formée dans le substrat et en contact avec un conducteur de masse (18) du circuit, cette région superficielle constituant une seconde région extrême de la succession des quatre régions de types de conductivité alternés formant le thyristor,
- un caisson de type N- (12) diffusé dans le substrat et séparé de ladite région superficielle par une zone de substrat de type P-, cette zone constituant une deuxième région intermédiaire du thyristor et le caisson constituant la première région intermédiaire dite région de gâchette,
- une région (22) de type P+ formée superficiellement dans le caisson et constituant ladite première région extrème du thyristor, en contact électrique direct avec le plot de connexion,
- et une résistance reliant le plot et la région de gâchette.

5. Circuit selon la revendication 4, caractérisé en ce qu'il comporte une cinquième région, de type N+, (26) diffusée superficiellement au dessus du caisson, cette région formant un contact ohmique pour une liaison électrique entre une extrémité de la résistance et le caisson N-, l'autre extrémité de la résistance étant reliée directement au plot.

6. Circuit selon la revendication 5, caractérisé en ce que la cinquième région (26) s'étend à la fois au dessus du caisson et dans le substrat hors du caisson, et en ce qu'elle est reliée, à une extrémité située hors du caisson, à un conducteur (E) d'entrée du circuit intégré.

7. Circuit selon l'une des revendications 5 ou 6, caractérisé en ce que la résistance (R1) est constituée par une couche de métal ou de silicium polycristallin en contact à une extrémité avec le plot et à une autre extrémité avec une partie de la cinquième région située au dessus du caisson N-.

8. Circuit selon l'une des revendications 4 à 7, caractérisé en ce qu'une sixième région (34), de type N+, est formée superficiellement dans le caisson, écartée de la quatrième région de type P+, cette région étant en contact électrique direct avec le plot.

9. Circuit selon l'une des revendications 4 à 8, caractérisé en ce qu'il comprend une région (30) de type P+ formée superficiellement dans le substrat et reliée directement au conducteur de masse (18).

10. Circuit selon l'une des revendications 4 à 9, caractérisé en ce que les diverses régions superficielles dopées de type P+ et N+ sont séparées les unes des autres par des zones d'oxyde épais.

11. Circuit selon l'une des revendications 4 à 10, caractérisé en ce que la résistance réalisée en métal ou en silicium polycristallin a une valeur de 0,6 ohms à 6 ohms.

## Patentansprüche

1. Integrierter Schaltkreis mit wenigstens einem Kontakt für eine externe Verbindung (PL) und einer Vorrichtung zum Schutz gegen Überspannungen, die an dem Kontakt insbesondere aufgrund elektrostatischer Entladungen auftreten können, wobei diese Vorrichtung zum Schutz eine integrierte Thyristorstruktur umfaßt, die zwischen dem Kontakt und einer elektrischen Masse (18) des Schaltkreises geschaltet ist, wobei dieser Thyristor vier alternierende aufeinanderfolgende Halbleiterbereiche PNPN (22, 12, 20, 16) umfaßt, bei denen ein erster Randbereich der Folge (22) und ein erster Zwischenbereich (12), Gatebereich genannt, neben dem ersten Randbereich über einen niederohmigen Widerstand (R1) zwischen dem Gatebereich und dem Kontakt mit dem Kontakt verbunden ist,
dadurch gekennzeichnet, daß der Widerstand einen ausreichend niedrigen Wert hat, damit die Spannung an den Anschlüssen der Vorrichtung, wenn sie einmal eingeschaltet ist, niedriger ist, wenn die Überspannung von einer großen Leistung kommt, als wenn die Überspannung von einer niedrigen Leistung kommt.

2. Integrierter Schaltkreis nach Anspruch 1, dadurch gekennzeichnet, daß der Widerstand in Form von Metall oder polycristallinem Silizium vorliegt und einen Wert hat, so daß der Strom zum Auslösen der Leitfähigkeit des Thyristors zwischen 100 Milliampere und 1 Ampere liegt.

3. Integrierter Schaltkreis nach einem der Ansprüche 1 und 2, dadurch gekennzeichnet, daß der Widerstand einen Wert zwischen 0,6 und 6 Ohm hat.

4. Integrierter Schaltkreis nach einem der Ansprüche 1 bis 3, dadurch gekennzeichnet, daß die Schutzvorrichtung umfaßt:
- ein P-dotiertes Substrat,
- einen Oberflächenbereich (16) der auf dem Substrat und in
- Kontakt mit dem Masseleiter (18) des Schaltkreises der N⁺-
- dotiert ist, wobei dieser Oberflächenbereich einen zweiten
- Randbereich in der Folge der vier Bereiche mit alternie-
- render Leitfähigkeit darstellt, die den Thyristor bilden,
- ein N⁻-dotierters Gehäuse (12), das in das Substrat eindiffundiert wurde und von dem Oberflächenbereich durch eine P⁻-dotierte Substratzone getrennt ist, wobei diese Zone einen zweiten Zwischenbereich des Thyristors bildet und das Gehäuse den ersten Zwischenbereich bildet, der Gatebereich genannt wird,
- einen P⁺-dotierten Bereich (22), der sich auf der Oberfläche des Gehäuses befindet und den besagten ersten Randbereich des Thyristors bildet, der direkt mit dem Verbindungskontakt elektrisch verbunden ist, und
- einen Widerstand, der den Kontakt mit dem Gatebereich verbindet.

5. Schaltkreis nach Anspruch 4, dadurch gekennzeichnet, daß er einen fünften Bereich vom N⁺-Typ (26) umfaßt, der oberflächlich auf das Gehäuse aufgebracht wurde, wobei dieser Bereich einen ohmschen Kontakt zur elektrischen Verbindung eines Endes des Widerstands und des N⁻-Gehäuses darstellt, wobei das andere Ende des Widerstandes direkt mit dem Kontakt verbunden ist.

6. Schaltkreis nach Anspruch 5, dadurch gekennzeichnet, daß der fünfte Bereich (26) sich sowohl oberhalb des Gehäuses als auch im Substrat außerhalb des Gehäuses erstreckt, und dadurch, daß er an einem Ende außerhalb des Gehäuses mit einem Leiter (E) vom Eingang des integrierten Schaltkreises verbunden ist.

7. Schaltkreis nach einem der Ansprüche 5 oder 6, dadurch gekennzeichnet, daß der Widerstand (R1) aus einer Metall- oder polycristallinen Siliziumschicht an einem Ende mit dem Kontakt und am anderen Ende mit einem Teil des fünften Bereichs oberhalb des N⁻-Gehäuses verbunden ist.

8. Schaltkreis nach einem der Ansprüche 4 bis 7, dadurch gekennzeichnet, daß ein sechster Bereich (34) vom N⁺-Typ oberflächlich in dem Gehäuse gebildet ist, beabstandet vom vierten Bereich vom P⁺-Typ, wobei dieser Bereich elektrisch direkt mit dem Kontakt verbunden ist.

9. Schaltkreis nach einem der Ansprüche 4 bis 8, dadurch gekennzeichnet, daß er einen Bereich (30) vom P⁺-Typ umfaßt, der sich oberflächlich auf dem Substrat befindet und direkt mit dem Masseleiter (18) verbunden ist.

10. Schaltkreis nach einem der Ansprüche 4 bis 9, dadurch gekennzeichnet, daß die unterschiedlichen oberflächlichen Bereiche vom P⁺- und N⁺-Typ durch dicke Oxidschichten voneinander getrennt werden.

11. Schaltkreis nach einem der Ansprüche 4 bis 10, dadurch gekennzeichnet, daß der Widerstand in Form von Metall oder polycristallinem Silizium einen Wert zwischen 0,6 und 6 Ohm hat.

## Claims

1. Integrated circuit having at least one external connection pin (PL) and a device for protecting against any overvoltages liable to appear at this pin notably because of electrostatic discharges, this protection device having an integrated thyristor structure connected between the pin and an electrical earth (18) of the circuit, this thyristor comprising four successive alternating pnpn semi-conductor regions (22, 12, 20, 16) of which a first end region of the alternation (22) and a first intermediate region (12) referred to as the gate region adjacent to the first end region are connected to the pin, with a low-value resistance (R1) interposed between the gate region and the pin, characterised in that the resistance has a sufficiently low value for the voltage at the terminals of the device, once triggered, to be lower when the overvoltage is of high power than when the overvoltage is of low power.

2. Integrated circuit according to Claim 1, characterised in that the resistance, produced from metal or polycrystalline silicon, has a value such that the current triggering the conduction of the thyristor is from 100 milliamperes to 1 ampere.

3. Integrated circuit according to one of Claims 1 to 2, characterised in that the resistance has a value of 0.6 to 6 ohms.

4. Integrated circuit according to one of Claims 1 to 3, characterised in that the protection device includes:
- a p- doped substrate,
- a surface region (16), n+ doped, formed in the substrate and in contact with an earth conductor (18) of the circuit, this surface region constituting a second end region of the succession of four regions of alternating conductivity types forming the thyristor,
- an n- type well (12) diffused in the substrate and separated from the said surface region by a p- type substrate area, this area constituting a second intermediate region of the thyristor and the well constituting the first intermediate region referred to as the gate region,
- a p+ type region (22) formed superficially in the well and constituting the said first end region of the thyristor, in direct electrical contact with the connection pin, and
- a resistance connecting the pin and the gate region.

5. Circuit according to Claim 4, characterised in that it includes a fifth region (26), of n+ type, diffused superficially above the well, this region forming an ohmic contact for an electrical connection between one end of the resistance and the n- type well, the other end of the resistance being connected directly to the pin.

6. Circuit according to Claim 5, characterised in that the fifth region (26) extends both above the well and in the substrate outside the well, and in that it is connected, at an end situated outside the well, to an input conductor (E) of the integrated circuit.

7. Circuit according to one of Claims 5 or 6, characterised in that the resistance (R1) consists of a layer of metal or polycrystalline silicon in contact at one end with the pin and at another end with a part of the fifth region situated above the n-type well.

8. Circuit according to one of Claims 4 to 7, characterised in that a sixth region (34), of n+ type, is formed superficially in the well, separated from the fourth p+ type region, this region being in direct electrical contact with the pin.

9. Circuit according to one of Claims 4 to 8, characterised in that it comprises a p+ type region (30) formed superficially in the substrate and connected directly to the earth conductor (18).

10. Circuit according to one of Claims 4 to 9, characterised in that the various p+ and n+ doped surface regions are separated from each other by thick oxide areas.

11. Circuit according to one of Claims 4 to 10, characterised in that the resistance produced from metal or polycrystalline silicon has a value of 0.6 ohms to 6 ohms.
